# EUROPEAN PATENT APPLICATION

(11) **EP 3 907 758 A1**
(43) Date of publication of application: **10.11.2021**
(21) Application number: 20173715.2
(22) Date of filing: 08.05.2020
(51) Int. Cl.: H01L 23/485, H01L 23/49, H01L 21/60, H01L 29/423

(54) **SEMICONDUCTOR DIE, SEMICONDUCTOR SWITCHING ASSEMBLY AND METHOD OF MANUFACTURING**

(71) Applicant: Infineon Technologies AG, 85579 Neubiberg (DE)
(72) Inventor: PETERS, Dethard, 91315 Hoechstadt (DE); HILSENBECK, Jochen, 9500 Villach (AT); BOLOWSKI, Daniel, 59519 Moehnsee (DE)
(74) Representative: Müller Hoffmann & Partner

(57) **Abstract**

A semiconductor die (500) includes a semiconductor body (100) with a cell array section (610). In the cell array section (610) a first surface (101) of the semiconductor body (100) comprises stripe-shaped contact areas (105) that extend along a lateral first direction (901) at least from a first edge (611) of the cell array section (610) to an opposite second edge (612). A plurality of dielectric stripes (210) is formed on the first surface (101). Each of the dielectric stripes (210) is located between two neighboring contact areas (105). A source pad portion (316) is above the cell array section (610). Source contact structures (315) extend between the dielectric stripes (210) from the source pad portion (316) to the contact areas (105). A plurality of dielectric bars (220) is formed on at least one of the contact areas (105) at a distance to a perimeter of the cell array section (610), wherein each of the dielectric bars (220) connects two neighboring ones of the dielectric stripes (210).

## Description

### TECHNICAL FIELD

Examples of the present disclosure relate to a semiconductor die with dielectric stripes formed on a semiconductor body. Further examples relate to a semiconductor switching assembly including a semiconductor die and a bond wire and to a method of manufacturing a semiconductor switching assembly including one or more semiconductor dies.

Wire bonding is an interconnection technique for electrically connecting bare semiconductor dies to the terminals of a chip package or to a base substrate such as a PCB (printed circuit board) or DBC (direct bonded copper) substrate. In power modules such as bridge rectifiers, half-bridge switching assemblies or H-bridge switching assemblies, bond wires connect contact pads on the semiconductor dies with contact pads on other semiconductor dies or with metal support structures formed directly on the substrate.

There is a need for semiconductor dies that can be efficiently and variably used in wire bonding processes.

### SUMMARY

An embodiment of the present disclosure relates to a semiconductor die. The semiconductor die includes a semiconductor body with a cell array section. In the cell array section a first surface of the semiconductor body includes stripe-shaped contact areas that extend along a lateral first direction from a first edge of the cell array section to an opposite second edge. A plurality of dielectric stripes is formed on the first surface. Each of the dielectric stripes is located between two neighboring contact areas. A source pad portion is above the cell array section. Source contact structures extend between the dielectric stripes from the source pad portion to the contact areas. A plurality of dielectric bars is formed on at least one of the contact areas at a distance to a perimeter of the cell array section, wherein each of the dielectric bars connects two neighboring ones of the dielectric stripes.

Those skilled in the art will recognize additional features and advantages upon reading the following detailed description and on viewing the accompanying drawings.

### BRIEF DESCRIPTION OF THE DRAWINGS

The accompanying drawings are included to provide a further understanding of the embodiments and are incorporated in and constitute a part of this specification. The drawings illustrate embodiments of a semiconductor die, a semiconductor switching assembly and a method of manufacturing a semiconductor switching assembly and together with the description serve to explain principles of the embodiments. Further embodiments are described in the following detailed description and the claims.
FIG. 1A shows a simplified plan view of a portion of a semiconductor die including dielectric stripes and dielectric bars connecting neighboring dielectric stripes according to an embodiment.
FIGS. 1B-1D show an enlarged plan view and two corresponding vertical cross-sectional views of the semiconductor die of FIG. 1A.
FIGS. 2A-2C show a simplified plan view and two parallel vertical cross-sectional views of a semiconductor die according to an embodiment with planar gate structures.
FIGS. 3A-3C show a simplified plan view and two parallel vertical cross-sectional views of a semiconductor die according to an embodiment with trench gate structures and planar source contact structures.
FIGS. 4A-4C show a simplified plan view and two parallel vertical cross-sectional views of a semiconductor die according to an embodiment with trench gate structures and source trench contacts.
FIG. 5 shows a simplified plan view of a semiconductor die with a source pad and four bonding areas according to another embodiment.

### DETAILED DESCRIPTION

In the following detailed description, reference is made to the accompanying drawings, which form a part hereof and in which are shown by way of illustrations specific embodiments in which a semiconductor die, a semiconductor switching assembly and a method of manufacturing a semiconductor switching assembly may be practiced. It is to be understood that other embodiments may be utilized and structural or logical changes may be made without departing from the scope of the present disclosure. For example, features illustrated or described for one embodiment can be used on or in conjunction with other embodiments to yield yet a further embodiment. It is intended that the present disclosure includes such modifications and variations. The examples are described using specific language, which should not be construed as limiting the scope of the appending claims. The drawings are not scaled and are for illustrative purposes only. Corresponding elements are designated by the same reference signs in the different drawings if not stated otherwise.

The terms "having", "containing", "including", "comprising" and the like are open, and the terms indicate the presence of stated structures, elements or features but do not preclude the presence of additional elements or features. The articles "a", "an" and "the" are intended to include the plural as well as the singular, unless the context clearly indicates otherwise.

The term "electrically connected" describes a permanent low-resistive ohmic connection between electrically connected elements, for example a direct contact between the concerned elements or a low-resistive connection via a metal and/or heavily doped semiconductor material. An "ohmic contact" is a non-rectifying electrical junction with a linear or almost linear current-voltage characteristic.

Ranges given for physical dimensions include the boundary values. For example, a range for a parameter y from a to b reads as a ≤ y ≤ b. The same holds for ranges with one boundary value like "at most" and "at least".

The term "power semiconductor device" refers to semiconductor devices with a high voltage blocking capability of at least 30 V, for example 100 V, 600 V, 1.6 kV, 3.3 kV or more and with a nominal on-state current or forward current of at least 1 A, for example 10 A or more.

A semiconductor die includes the semiconducting portions of a semiconductor device and further structures typically formed at wafer level. For example, the semiconductor die may include a semiconductor body, a front side metallization at a front side of the semiconductor body and a back side metallization at a side of the semiconductor body opposite to the front side. The front side metallization may include one or more metal pads. A load current may flow from the metal pads through the semiconductor body to the back side metallization or from the back side metallization to the metal pads.

A semiconductor device includes at least one semiconductor die and at least one further structure formed after separation of the semiconductor die from a wafer composite. For example, a semiconductor device may include a semiconductor die, terminals, and bond wires connecting the terminals with the metal pads of the semiconductor die.

A semiconductor die may include a semiconductor body with two essentially parallel main surfaces, which may have approximately the same shape and size. A lateral surface area connects the edges of the two main surfaces. The semiconductor body may be a cylinder, e.g. a right cylinder. Alternatively, the semiconductor body may be polygonal, e.g. rectangular or hexagonal prism, e.g. right prism, with or without rounded edges. The semiconductor body may have a surface extension along two horizontal directions and may have a thickness along a vertical direction perpendicular to the horizontal directions.

In the following, the horizontal directions are also referred to as lateral directions, the main surface at the front side is referred to as first surface and the main surface on the rear side of the semiconductor body is referred to as second surface.

The semiconductor body includes a semiconducting portion formed from a single crystalline semiconductor. The semiconductor may be a group IV elemental semiconductor, e.g. silicon (Si) or germanium (Ge), a group IV compound semiconductor, e.g. silicon carbide (SiC) or silicon germanium (SiGe), or a group III-V semiconductor such as gallium nitride (GaN) or gallium arsenide (GaAs), by way of example. In addition to the semiconducting portion, the semiconductor body may include functional structures from other materials like polycrystalline silicon, dielectrics, elemental metals, metal compounds and/or metal alloys. The functional structures may be formed in trenches extending from the first or second surface into the semiconducting portion or may be formed on the first surface and/or on the second surface.

For example, the material of the semiconducting portion may be single crystalline silicon SiC, for example 15R-SiC (silicon carbide with 15R-polytype), or silicon carbide with a hexagonal polytype like 2H-SiC, 4H-SiC or 6H-SiC. In addition to the main constituents, e.g. silicon and carbon, the semiconducting portion may include dopant atoms, for example nitrogen (N), phosphorous (P), beryllium (Be), boron (B), aluminum (Al) and/or gallium (Ga). The semiconductor body may also include further impurities such as hydrogen (H), fluorine (F) and/or oxygen (O).

The semiconductor body may include one or more cell array sections and a peripheral section. Neighboring cell array sections are arranged side-by side in the horizontal plane. Neighboring cell array sections may directly adjoin each other or may be separated by non-array sections. The peripheral section may completely surround the cell array section or the plurality of cell array sections. The peripheral section may directly adjoin the lateral surface and may separate the cell array section or the cell array sections from the lateral surface.

Each cell array section may include source regions, body regions and gate electrodes of operational transistor cells. Operational transistor cells turn on and off in response to a potential applied to the gate electrode. When turned on, an operational transistor cell conducts a portion of a load current between the source region and a drain/drift structure, which may be formed in the semiconductor body between the transistor cells and the second surface.

In a lateral first direction, the cell array section may end at the first wiring line extending cross-wise to the gate electrodes or at a line connecting the ends of the gate electrodes at the same side, whichever is closer to a cell array section center.

Orthogonal to the first direction, the cell array section may end at the outer edges of the source regions of the outermost operational transistor cells or at the outer edge of the gate electrode of the outermost operational transistor cells, whichever is farther from the cell array section center.

The cell array section may have a rectangular shape with a first edge, a second edge opposite to the first edge, a third edge, and a fourth edge opposite to the third edge.

The first surface may include a plurality of stripe-shaped contact areas that may extend along the first direction from the first edge to the second edge and parallel to the third and fourth edges. The contact areas may be rectangular subsections of the first surface. A width of each contact area along the first direction may be uniform. The contact areas may run parallel to each other. A center-to-center distance between neighboring contact areas may be uniform within each cell array section. Within at least portions of the contact areas, the source regions or the source and body regions extend from the first surface into the semiconductor body. Each contact area may be planar or may include sidewalls and bottom area of one or more contact trenches extending from the first surface into the semiconductor body.

A plurality of dielectric stripes may be formed on the first surface. Each of the dielectric stripes may be formed between two neighboring contact areas. Dielectric stripes and contact areas may strictly alternate orthogonal to the first direction. The dielectric stripes have a length along the lateral first direction. The dielectric stripes may extend from the first edge of the cell array section to the opposite second edge or may extend beyond the first edge, beyond the second edge or beyond the first and second edges.

Each dielectric stripe includes at least one dielectric layer. The dielectric stripes may be completely made from one or more dielectric materials. According to another example, the dielectric stripes may include a conductive structure covered and/or encapsulated by one or more dielectric layers. The dielectric material(s) may include at least one of thermally grown silicon oxide, deposited silicon oxide, undoped silicate glass, doped silicate glass, silicon nitride, or silicon oxynitride, by way of example.

Each dielectric stripe may be formed completely above the first surface. Alternatively, each dielectric stripe may include a portion extending from the first surface into the semiconductor body.

A source pad portion may be formed on the cell array section. The semiconductor die may include one single source pad portion. Alternatively, the semiconductor die may include a plurality of source pad portions, wherein each source pad portion is assigned to one single cell array section. The source pad portion may be a metal structure. The source pad portion may be a rectangular portion of a source pad in the vertical projection of not more than one cell array section. The source pad portion may laterally extend beyond an outer perimeter of the cell array section along one, two, three or each of the four edges. According to an example, the source pad portion does not laterally overlap with a further cell array section.

Source contact structures may extend between the dielectric stripes from the source pad portion to the contact areas. The source contact structures may include one or more metal portions, for example a thin metal liner extending along vertical sidewalls of the dielectric stripes. Each source contact structure may include rounded corners in the horizontal cross-section.

A plurality of dielectric bars may be formed on at least one of the contact areas at a distance to the outer perimeter of the cell array section. Each of the dielectric bars connects two neighboring ones of the dielectric stripes. For example, a plurality of dielectric bars and the two neighboring dielectric stripes may form a ladder-like structure with the dielectric stripes forming the rails and the dielectric bars forming the rungs.

The dielectric bars may include one or more dielectric layers. The dielectric material(s) may include at least one of thermally grown silicon oxide, deposited silicon oxide, undoped silicate glass, doped silicate glass, silicon nitride, or silicon oxynitride, by way of example. The dielectric stripes and the dielectric bars may include the same dielectric material(s). For example, the dielectric bars and the dielectric stripes may have the same structural and material configuration.

A center-to-center distance between neighboring dielectric bars may be uniform along each contact area or may steadily increase with increasing distance to the center of the cell array section. The dielectric bars in neighboring contact areas may be identically arranged or may be shifted to each other along the first direction. For example, the dielectric bars in neighboring contact areas may be shifted relative to each other by the half center-to-center distance along the first direction.

The dielectric bars may mechanically reinforce the dielectric stripes against mechanical forces with a component effective in a direction tilted to the first direction. In particular, the dielectric bars may strengthen the dielectric stripes against mechanical forces acting orthogonally to the first direction. For example, an ultrasonic wire bonding process may utilize a horizontal ultrasonic vibration and a simultaneous normal bond force to bond a wire on a top surface of the source pad portion. The amplitude of the horizontal vibration may have a component directed parallel to a longitudinal axis of the bond wire. The horizontal vibrations may couple into the source pad portion and may cause periodical mechanical sheer stress in the structures underlying the source pad portion, e.g., in the dielectric stripes. The mechanical stress may cause cracks in the dielectric stripes and/or may cause the dielectric stripes to partially collapse. The dielectric bars may reinforce the dielectric stripes against mechanical stress applied orthogonally to the first direction and may improve the ruggedness of the dielectric stripes for the wire bonding process.

The bonding wires can be bonded to the source pad along each direction, irrespectively of the orientation of the dielectric stripes. In particular, the bonding wires may be drawn tilted, e.g. orthogonal to the first direction without significantly damaging the dielectric stripes.

According to an embodiment stripe-shaped gate electrodes may extend at least from the first edge to the second edge of the cell array section. In case the semiconductor die includes more than one cell array section, the stripe-shaped gate electrodes may extend across all cell array sections arranged along the first direction. Each of the gate electrodes is separated from the source pad portion by at least one dielectric layer of the dielectric stripes.

The gate electrodes may be planar gate electrodes formed on the first surface. For example, a gate dielectric is formed on the first surface, the gate electrodes are formed on the gate dielectric, and an interlayer dielectric covers a top surface and the sidewalls of the gate electrodes. Each dielectric stripe includes the gate electrode and the interlayer dielectric covering the gate electrode.

According to another example the gate electrodes are formed in gate trenches that extend from the first surface into the semiconductor body. The dielectric stripes are formed on the gate electrodes, wherein the dielectric stripes may be formed completely or almost completely above the first surface or may extend into an upper portion of the gate trenches.

With the dielectric bars stabilizing the dielectric stripes, it may become possible to bond wires in all directions onto the source pad without loss of yield and without increasing the gate resistance, e.g. for topologies with long gate electrodes. In particular, the dielectric bars allow the use of ultrasonic bonding regardless the orientation of the direction of the amplitude of the ultrasonic vibrations with respect to the orientation of the gate electrodes. The dielectric bars may contribute to avoiding short-circuits between the gate electrodes and the source pad due to cracks in the dielectric stripes.

In combination with a layout of the semiconductor die including a plurality of cell array sections arranged side-by-side along the first direction, the dielectric bars facilitate the formation of gate fingers extending between the source pad portions. The gate fingers reduce a time lag between the switching of the fastest transistor cell and the switching of the slowest transistor cell of the semiconductor die.

According to an embodiment the source pad portion may have a pad width along the first direction and a pad length orthogonal to the first direction. The pad length may be at least 150% of the pad width. A bond wire may be bonded onto the source pad portion with the longitudinal axis of the bond wire orthogonal or almost orthogonal to the first direction.

According to an embodiment the source pad portion may have a top surface with a top surface area, wherein the top surface area includes a bonding area that is smaller than the top surface area. Within a perimeter of the bonding area, the dielectric bars may cover a greater area portion of the contact areas than outside the perimeter of the bonding area. Shape, maximum width and maximum length of the bonding area result from the actual area, in which the bond wire is connected to the source pad portion and to process margins for placing the wire bond. By providing the dielectric bars mainly or exclusively in the bonding area, an adverse impact of the dielectric bars on the on-state resistance can be reduced without reducing the mechanical strength of the dielectric stripes in portions, where the dielectric bars are highly efficient.

According to an embodiment a ratio between the bonding area and the top surface area is at least 10% and at most 90%. In each case, reducing the area occupied by the dielectric bars selectively outside the bonding area reduces the risk for mechanically damaging the dielectric stripes, e.g., during ultrasonic bonding.

According to an embodiment the bonding area may be located at a distance to at least one edge of the source pad portion. For example, the bonding area is located at a distance to two, three or all four edges of the source pad portion.

According to an embodiment at least two source pad portions may be arranged parallel to each other along the first direction. For example, three, four or more source pad portions may be arranged along the first direction. Between each pair of source pad sections, a gate finger may be provided that electrically connects the gate electrodes. The gate electrodes may extend without interruptions across a plurality of cell arrays. The gate fingers may reduce the mean gate electrode resistance.

According to an embodiment the dielectric bars have a bar length along the first direction and a bar width orthogonal to the first direction. A mean bar length of the dielectric bars may be greater than the bar width. The bar width is equal to the width of the contact area. The bar length may be at least twice the bar width.

All dielectric bars assigned to the same contact area may have the same bar length. All dielectric bars assigned to the same contact area may have the same center-to-center distance to the neighboring dielectric bar. Alternatively, the center-to-center distance between neighboring dielectric bars crossing the same contact area may increase with decreasing distance to the first edge and/or with decreasing distance to the second edge.

According to an embodiment each of the source contact structures extending between two neighboring ones of the dielectric bars and two neighboring ones of the dielectric stripes has a contact length along the first direction. A mean contact length of source contact structures, which are in contact with the same contact area, may be smaller than a mean bar length.

All contacts assigned to the same contact area may have the same contact length. Alternatively, the contact length may increase with decreasing distance to the first edge and/or with decreasing distance to the second edge. For example, the mean contact length may be in a range from 2.4 µm to 4.3 µm. A mean bar length may be in a range from 1.5 µm to 2 µm, for example about 1.8 µm.

According to an embodiment, lateral edges of the contact structures may be rounded. The rounded edges may make the dielectric bars less susceptible for the formation of mechanical cracks.

According to an embodiment the vertical extension of the dielectric stripes may be at least 100nm, e.g. at least 200nm. For example, the vertical extension of the dielectric stripes may be at least 500nm or at least 1µm. The dielectric stripes may consist of deposited silicon oxide or may include a layer of deposited silicon oxide. The dielectric bars are adapted to stabilize higher aspect ratio structures made from brittle materials.

According to an embodiment a semiconductor switching assembly includes a bond wire bonded onto the source pad portion of the semiconductor die. A horizontal angle between a longitudinal axis of the bond wire and the first direction is in a range from 60° to 120°, for example from 75° to 105°. The bond wire is bonded onto the source pad portion in the bond area. The dielectric bars may allow the bond wire to be connected to the source pad portion by ultrasonic bonding without significant damage of the dielectric stripes and the gate electrodes. In particular, the bond wire may be ultrasonic bonded without the risk of forming short-circuits between the gate electrodes and the source pad portion.

According to an embodiment the semiconductor switching assembly may further include a bond pad, wherein the bond wire is further bonded onto the bond pad and connects the bond pad and the source pad portion of the semiconductor die.

For example, the semiconductor switching assembly is a semiconductor device including at least a gate terminal, a first load terminal, a second load terminal, and a package encapsulating the semiconductor die and portions of the terminals. The bond pad may be a portion of a lead frame to which the semiconductor die is connected during manufacturing. The lead frame may later be separated into the first load terminal, the second load terminal and the gate terminal. The first load terminal may be the source terminal of a MOSFET or the emitter terminal of an IGBT, by way of example. The second load terminal may be the drain terminal of a MOSFET or the collector terminal of an IGBT, inter alia.

According to another example, the bond pad may be part of a further semiconductor die, wherein the two connected semiconductor dies may be electrically connected in parallel or in series. The two semiconductor dies may be of the same type. Alternatively, the two semiconductor dies may have different functionalities. For example, the further semiconductor die may be a freewheeling diode. Alternatively, the bond bad may be a metal conductor or metal plate formed on a surface of a passive substrate. The substrate may be a PCB or DBC substrate. For example, the semiconductor switching assembly is a power module such as a half-bridge switching assembly or an H-bridge switching assembly, by way of example.

Another embodiment refers to a method of manufacturing a semiconductor switching assembly. The semiconductor switching assembly may be a semiconductor device including a semiconductor die and terminals. Alternatively, the semiconductor switching assembly may be a power module including a plurality of interconnected semiconductor dies arranged on a common substrate. A bond wire may be bonded onto the source pad portion of the semiconductor die, e.g. by using ultrasonic vibrations. After bonding, the bond wire connects the bond pad and the source pad portion. A horizontal angle between a longitudinal axis of the bond wire in the first direction is in a range from 60° to 120°, for example from 75° to 105°.

According to an embodiment an amplitude (German: Auslenkung) of the ultrasonic vibration is parallel to a longitudinal axis of the bond wire. The semiconductor die with the dielectric bars as described above can be integrated in a device package or in a power module without restrictions concerning the orientation of the semiconductor die to the direction in which the bond wire is drawn.

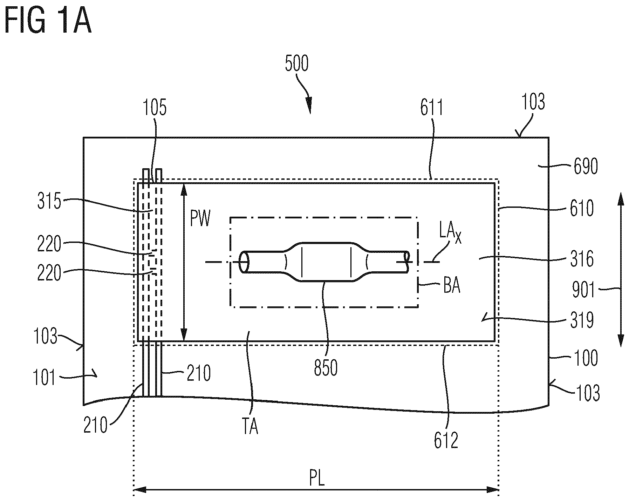

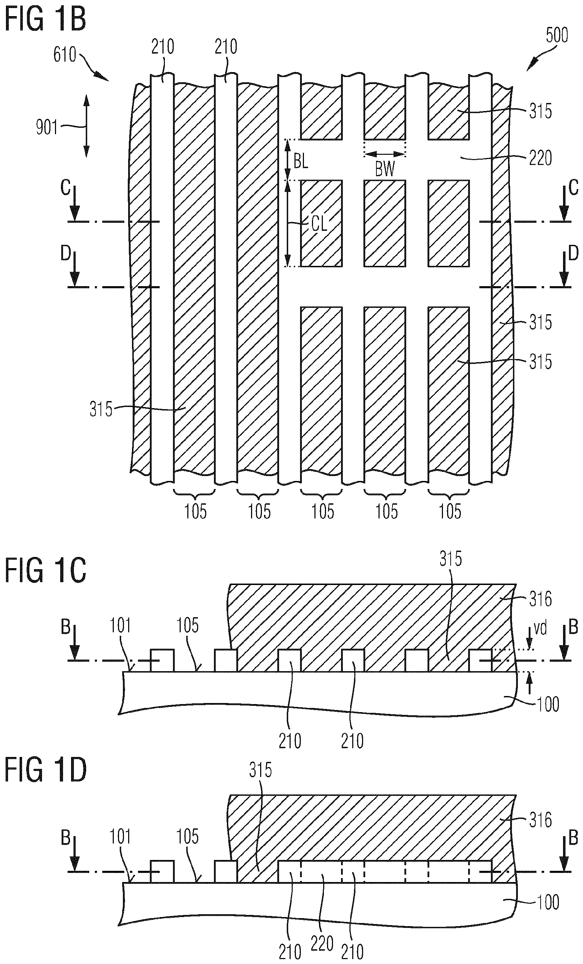

FIGS. 1A-1D illustrate a portion of a front side of a semiconductor die 500. The semiconductor die 500 may be a bare die of a power semiconductor device, for example an IGBT (insulated gate bipolar transistor), e.g. a reverse blocking IGBT or an RC-IGBT (reverse conducting IGBT), an MOSFET (metal oxide semiconductor field effect transistor), a JFET (junction field effect transistor) or an MGD (MOS gated diode).

The semiconductor die 500 includes a semiconductor body 100 with a first surface 101 at the front side. In a horizontal plane parallel to the first surface 101, the semiconductor body 100 may have a rectangular shape with or without rounded corners. A direction normal to the first surface 101 defines a vertical direction and directions orthogonal to the vertical direction are lateral directions. A second surface at the rear side of the semiconductor body 100 may have the same shape and size as the first surface 101 and may be oriented parallel or approximately parallel to the first surface 101. A lateral surface 103 connects the edges of the first surface 101 and the second surface.

The semiconductor body 100 includes one or more cell array sections 610 and a peripheral section 690. The peripheral section 690 directly adjoins the lateral surface 103 and separates the cell array section 610 or the cell array sections 610 from the lateral surface 103. The cell array section 610 may have a rectangular horizontal cross-section. Each cell array section 610 includes operational transistor cells. The peripheral section 690 is devoid of operational transistor cells.

Straight dielectric stripes 210 extend from a first edge 611 of the cell array section 610 to the opposite second edge 612. The dielectric stripes 210 have a length along a lateral first direction 901 and a width orthogonal to the first direction 901. The dielectric stripes 210 are formed completely or at least partly above the first surface 101. The dielectric stripes 210 are arranged parallel to each other along a direction orthogonal to the first direction 901. A center-to-center distance between neighboring dielectric stripes 210 may be uniform across the cell array section 610. Sections of the first surface 101 between the dielectric stripes 210 form contact areas 105. Further contact areas 105 may be formed on each one side of the cell array section 610 outside the outermost dielectric stripe(s) 210.

The dielectric stripes 210 may exclusively include dielectric materials or may include a conductive material in addition to dielectric materials, wherein the dielectric materials encapsulate the conductive material. The dielectric stripes 210 may include planar gate electrodes or may cover buried gate electrodes.

A source pad portion 316 is formed above the cell array section 610. The source pad portion 316 may include or consist of conductive material(s). The source pad portion 316 may include an elemental metal, a metal compound and/or a metal alloy. For example, the source pad portion 316 includes or consists of an alloy including copper (Cu) and aluminum (Al) as main constituents.

The source pad portion 316 may be a rectangular sub-portion of a source pad. The source pad may include more than one source pad portion 316 and may include further portions adjoining the source pad portion 316 and/or further portions structurally connecting neighboring source pad portions 316. Each source pad portion 316 has a pad width PW along the first direction 901 and a pad length PL orthogonal to the first direction 901. The pad length PL is greater than the pad width PW. A horizontal top surface 319 of the source pad portion 316 has a top surface area TA.

A bond wire 850 is bonded onto the top surface 319 within a bonding area BA. A longitudinal axis Lax of the bond wire 850 is oriented orthogonal or approximately orthogonal to the first direction 901. The bonding area BA is a sub-section of the top surface area TA. The bonding area BA is defined by the actual dimensions of a bonding foot formed by a portion of the bond wire 850 directly bonded onto the top surface 319 and by tolerance windows for the bonding process along the first direction 901 and orthogonal to the first direction 901. The bonding area BA may be rectangular, oval or elliptic.

As illustrated in FIG. 1A, the bonding area BA may have a maximum bond area width along the first direction 901 and a maximum bond area length orthogonal to the first direction 901. The bond area width may be in a range from 200µm to 2000pm. The bond area length may be in a range from 300µm to 3000pm. A ratio between bond area length and the bond area width may be at least 1.5, e.g. at least 2, or at least 3. Dielectric bars 220 structurally connect neighboring dielectric stripes 210. Each dielectric bar 220 extends from one dielectric stripe 210 to the neighboring dielectric stripe 210. The dielectric bars 220 and the dielectric stripes 210 may have the same vertical extension with respect to the first surface 101. The dielectric bars 220 may be formed exclusively within the bonding area BA or may be formed within the bonding area BA and outside the bonding area BA as illustrated in FIG.1A. In the latter case, outside the bonding area BA an area density ratio given by the total surface portion covered by the dielectric bars 220 to the total contact area 105 may be lower than within the bonding area BA.

The dielectric bars 220 have a maximum bar length BL along the first direction 901 and a maximum bar width BW orthogonal to the first direction 901. The bar length BL may be in a range from 0.5µm to 5pm, for example from 1µm to 2.5µm. The bar width BW may be in a range from 0.5µm to 5µm, for example from 1µm to 2.5µm.

Between the dielectric stripes 210 and the dielectric bars 220, source contact structures 315 extend from the source pad portion 316 to the contact areas 105. The contact structures 315 have a contact length CL along the first direction 901. The contact length CL may be in a range from 0.5µm to 10µm, for example from 2.4pm to 5µm. A contact width orthogonal to the first direction 901 and the bar width BW are equal.

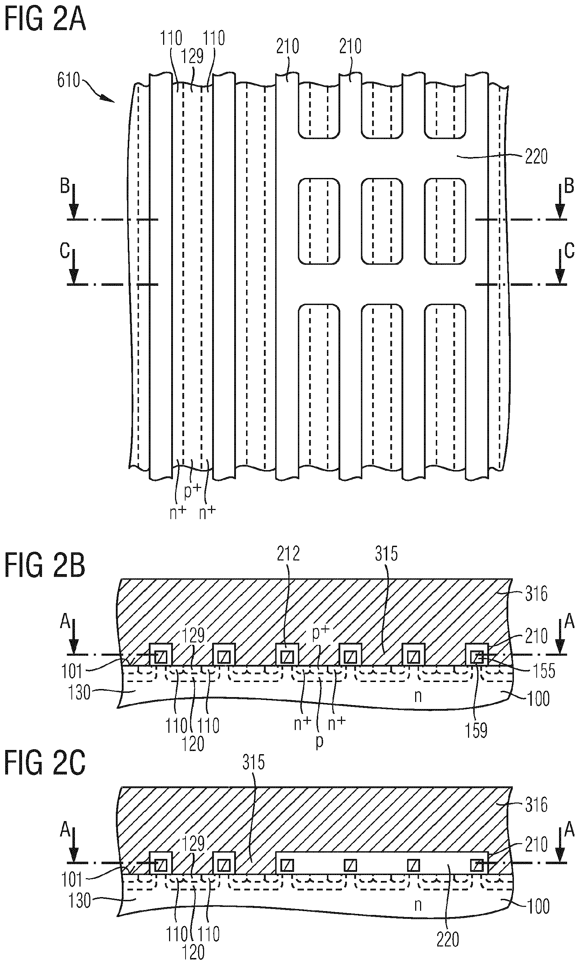

FIGS. 2A-2C refer to a cell array section 610 with planar transistor cells. Each dielectric stripe 210 includes a conductive gate electrode 155 and an interlayer dielectric 212 covering a top surface and sidewall surfaces of the gate electrode 155. A gate dielectric 159 separates the gate electrode 155 from the semiconductor body 100. P-type body regions 120 are formed in p-type wells extending from the contact areas 105 into the semiconductor body 100. In a lateral direction, the p-type body regions 120 extend to below the gate electrodes 155. N-type source regions 110 extend from the first surface 101 into the p-type wells and laterally extend to below the gate electrodes 155. Heavily p-doped body contact regions 129 are formed between neighboring source regions 110 and extend from the first surface 101 into the semiconductor body 100. The p-type body regions 120 separate the n-type source regions 110 and an n-type drain/drift structure 130.

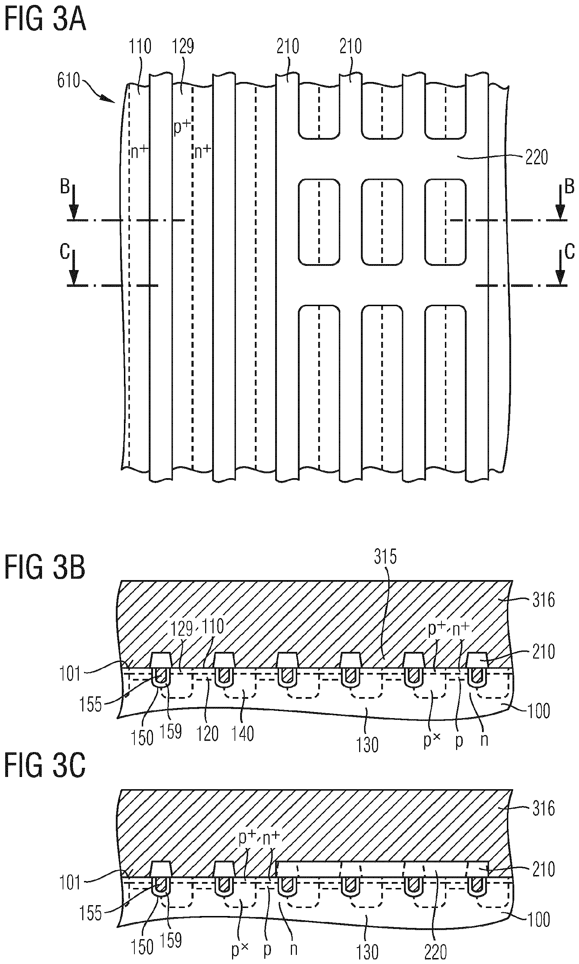

FIGS. 3A-3C refer to transistor cells with trench gate structures 150 extending from the first surface 101 into the semiconductor body 100. Each transistor cell is formed along one trench gate structure 150. A p-type body region 120 and an n-type source region 110 directly adjoin an active sidewall of the gate structure 150, wherein the source region 110 is formed between the body region 120 and the first surface 101. A p-type shielding region 140 is in contact with a passive sidewall of the trench gate structure 150. The shielding region 140 may extend deeper into the semiconductor body 100 than the trench gate structure 150 and may laterally extend to below the trench gate structure 150. A heavily doped p-type body contact region 129 and a source contact structure 315 form a low-resistive ohmic contact that electrically connects the shielding region 140 and the body region 120 with a source pad portion 316. Dielectric stripes 210 cover the trench gate structures 150. The dielectric stripes 210 may be completely formed from one dielectric material or from more than one dielectric material. Above the gate electrodes 155, the dielectric stripes 210 may partially extend to below the first surface 101.

In the illustrated embodiment, the source regions 110 and the body regions 120 are contiguous along the first direction 901 and may extend from a first edge of the cell array section 610 to an opposite second edge.

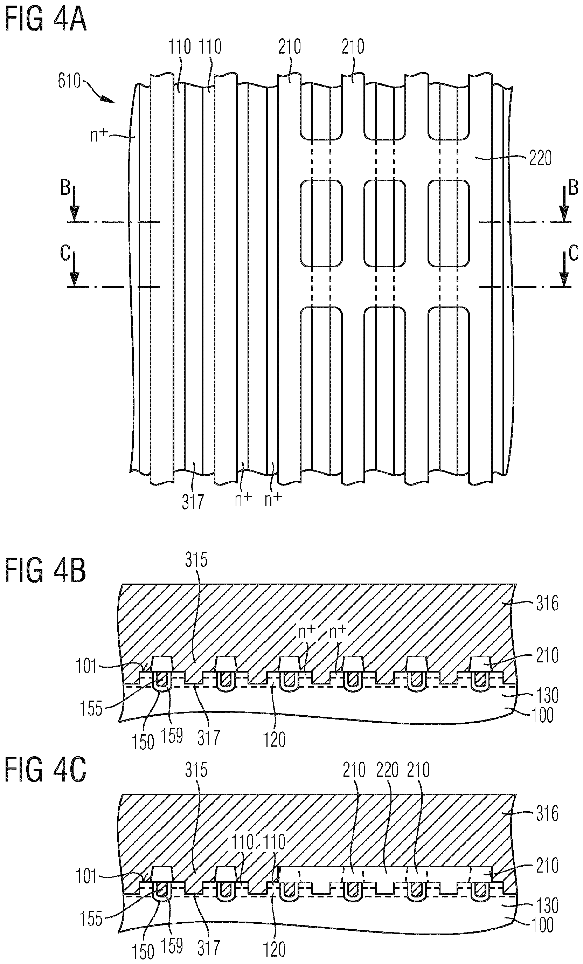

FIGS. 4A-4C refer to transistor cells with trench gate structures 150 and double-sided channel. Source regions 110 and body regions 120 may be formed on both longitudinal sidewalls of the trench gate structures 150. In addition, FIGS. 4B and 4C show source trench contacts 317 extending from the first surface 101 into the semiconductor body 100.

In the illustrated embodiment, the source regions 110, the body regions 120 and the trenches of the source trench contacts 317 are contiguous along the first direction 901 and may extend from the first edge of the cell array section 610 to the opposite second edge. The dielectric bars 220 may fill the sections of the trenches of the source trench contacts 317 below the dielectric bars 220.

According to other examples of the embodiments of FIGS. 3A-3C and 4A-4C, the source regions 110 may be interrupted and absent below the dielectric bars 220. For example, instead of the source regions 110 and body regions 120, lateral extension regions of the shielding regions 140 may be formed below the dielectric bars 220. The lateral extension regions may locally connect the shielding regions 140 assigned to neighboring gate structures 150 and may have the same or approximately the same vertical extension as the shielding regions 140.

The dielectric bars 220 may be formed at least partly, mainly or exclusively above lateral extension regions of the shielding regions 140. For embodiments with lateral shielding extensions below the dielectric bars 220, the dielectric bars 220 may be evenly distributed inside and outside the bonding area. In other words, an area density ratio given by the total surface portion covered by the dielectric bars 220 to the total surface portion of the contact areas 105 may be approximately the same inside and outside the bonding area BA.

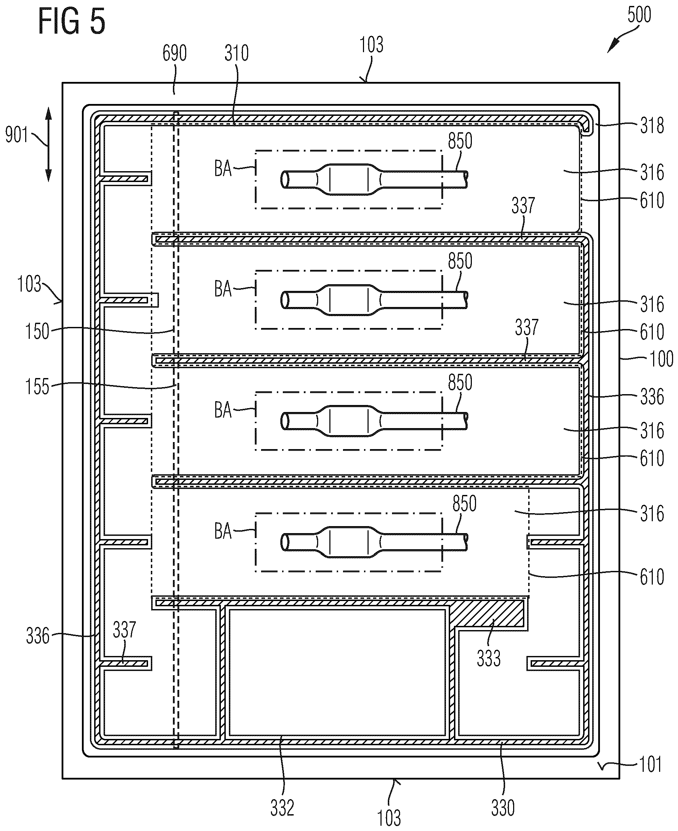

FIG. 5 illustrates a plan view of a front side metallization of a semiconductor die 500 with four source pad portions 316. Trench gate structures 150 with gate electrodes 155 extend along a first direction 901. The front side metallization may include a gate pad/wiring structure 330, a source pad 310, and a source wiring line 318 formed on the first surface 101 of a semiconductor body 100. The source wiring line 318 and the source pad 310 are electrically connected.

The gate pad/wiring structure 330 may include a gate pad 332, a gate runner 336 and gate fingers 337. Gate pad 332, gate runner 336 and gate fingers 337 may be directly electrically connected together. Alternatively, a gate resistor 333 may be electrically connected between the gate pad 332 and the gate runner 336.

The gate pad 332 may be comparatively thick. For example, a vertical extension of the gate pad 332 may be at least several micrometers. A minimum edge length of the gate pad 332 may be in a range of several 10 micrometers. The gate pad 332 forms a stable and rugged basis for a bonding wire and/or for sintering a metal clip onto a top surface of the gate pad 332. The gate pad 332 may include or consist of elemental copper (Cu), a copper aluminum alloy (CuAl), or a copper silicon aluminum alloy (CuSiAl).

The gate runner 336 may be formed in a peripheral section 690 and may form a closed frame or an open frame around a central portion of the first surface 101. Each gate finger 337 is structurally connected with the gate runner 336 and extends inwardly from the gate runner 336. Each gate finger 337 crosses several of the gate electrodes 155 and is electrically connected with the crossed gate electrodes 155. The gate runner 336 and the gate fingers 337 may have the same material and structural configuration as the gate pad 332. Alternatively, the gate runner 336 and the gate fingers 337 may be thinner than the gate pad 332.

The source wiring line 318 may surround the central portion of the first surface 101. For example, the source wiring line 318 may be formed between the gate runner 336 and the lateral surface 103. The source wiring line 318 may be in direct contact with a doped junction termination extension region formed in a peripheral section of the semiconductor body 100.

The source wiring line 318, the gate runner 336 and the gate fingers 337 may have the same or different structural and material configurations. For example, the source wiring line 318, the gate runner 336 and the gate fingers 337 may include a first thin layer, e.g. a titanium (Ti) layer, a titanium nitride (TiN) layer, a tantalum (Ta) layer, or a tantalum nitride (TaN) layer. In addition, at least one of the source wiring line 318, the gate runner 336 and the gate fingers 337 may include a second thin layer formed on the first thin layer, wherein the second layer may include another high conductive material, e.g. aluminum (Al). Alternatively or in addition, at least one of the source wiring line 318, the gate runner 336 and the gate fingers 337 may include a tungsten (W) portion.

The source pad 310 may be comparatively thick. For example, a vertical extension of the source pad 332 may be at least several micrometers. The source pad 310 may include or consist of elemental copper (Cu), a copper aluminum alloy (CuAl), or a copper silicon aluminum alloy (CuSiAl). The source pad 310 and the gate pad 330 may have the same structural and material configuration.

The source pad 310 includes several rectangular source pad portions 316 arranged along the first direction 901. Gate fingers 337 laterally separate neighboring source pad portions 316. In bonding areas BA of the source pad portions 3165, bond wires 850 are bonded onto the top surfaces 319 of four source pad portions 316. Longitudinal axes of the bond wires 850 are tilted to the first direction by about 90 degree.

Dielectric stripes (illustrated in FIG.1A, reference sign 210) are formed on the gate electrodes 155. Each dielectric stripe separates one gate electrode 155 from the source pad portions 316 formed above the gate electrode 155. Dielectric bars (illustrated in FIG.1A, reference sign 220) structurally connect neighboring dielectric stripes and mechanically stabilize the dielectric stripes during a bonding process which applies ultrasonic vibrations with the amplitude oriented horizontally and tilted to the first direction 901.

## Claims

1. A semiconductor die, comprising:
a semiconductor body (100) comprising a cell array section (610), wherein in the cell array section (610) a first surface (101) of the semiconductor body (100) comprises stripe-shaped contact areas (105) extending along a lateral first direction (901) at least from a first edge (611) of the cell array section (610) to an opposite second edge (612);
a plurality of dielectric stripes (210) formed on the first surface (101), wherein each of the dielectric stripes (210) is located between two neighboring contact areas (105);
a source pad portion (316) above the cell array section (610);
source contact structures (315) extending between the dielectric stripes (210) from the source pad portion (316) to the contact areas (105); and
a plurality of dielectric bars (220) formed on at least one of the contact areas (105) at a distance to a perimeter of the cell array section (610), wherein each of the dielectric bars (220) connects two neighboring ones of the dielectric stripes (210).

2. The semiconductor die according to the preceding claim, further comprising:
stripe-shaped gate electrodes (155) extending at least from the first edge (611) to the second edge (612), wherein each of the gate electrodes (155) is separated from the source pad portion (316) by a dielectric layer of the dielectric stripes (210).

3. The semiconductor die according to any of the preceding claims,
wherein the source pad portion (316) has a pad width (PW) along the first direction (901) and a pad length (PL) orthogonal to the first direction (901), wherein the pad length (PL) is at least 150% of the pad width (PW).

4. The semiconductor die according to any of the preceding claims,
wherein the source pad portion (316) has a top surface (317) with a top surface area (TA) comprising a bonding area (BA) smaller than the top surface (TA), and
wherein within a perimeter of the bonding area (BA), the dielectric bars (220) cover a greater area portion of the contact areas (105) than outside the perimeter of the bonding area (BA).

5. The semiconductor die according to the preceding claim,
wherein a ratio between the bonding area (BA) and the top surface area (TA) is at least 10% and at most 90%.

6. The semiconductor die according to any of the two preceding claims,
wherein the bonding area (BA) is located at a distance to at least one edge of the source pad portion (316).

7. The semiconductor die according to any of the preceding claims,
wherein at least two source pad portions (316) are arranged parallel to each other along the first direction (901).

8. The semiconductor die according to any of the preceding claims,
wherein each of the dielectric bars (220) has a bar length (BL) along the first direction (901) and a bar width (BW) orthogonal to the first direction (901), and
wherein a mean bar length (mBL) of the dielectric bars (220) is greater than the bar width (BW).

9. The semiconductor die according to any of the preceding claims,
wherein each of the source contact structures (315) extending between two neighboring ones of the dielectric bars (220) and two neighboring dielectric stripes (210) has a contact length (CL) along the first direction (901),
and wherein a mean contact length (mCL) of source contact structures (316) in contact with the same contact area (105) is smaller than a mean bar length (mBL).

10. The semiconductor die according to any of the preceding claims,
wherein a vertical extension of the dielectric stripes (210) is at least 200nm and wherein the dielectric stripes (210) comprise deposited silicon oxide.

11. A semiconductor switching assembly comprising the semiconductor die according to any of the preceding claims, further comprising:
a bond wire (850) bonded onto the source pad portion (316) of the semiconductor device (500), wherein a horizontal angle between a longitudinal axis (Lax) of the bond wire (850) and the first direction (901) is in a range from 60 degree to 120 degree.

12. The semiconductor switching assembly according to the preceding claim, further comprising:
a bond pad (810), wherein the bond wire (850) is bonded onto the bond pad (810) and connects the bond pad (810) and the source pad portion (316) of the semiconductor device (500).

13. A method of manufacturing a semiconductor switching assembly, the method comprising:
providing a bond pad (810) and the semiconductor die according to any of claims 1 to 10;
bonding a bond wire (850) onto the source pad portion (316) using ultrasonic vibrations, wherein the bonded bond wire (850) connects the bond pad (810) and the source pad portion (316), and wherein a horizontal angle between a longitudinal axis of the bond wire (850) and the first direction (901) is in a range from 60 degree to 120 degree.

14. The method according to the preceding claim, wherein
an amplitude of the ultrasonic vibration is directed parallel to the longitudinal axis (Lax) of the bond wire (850).

## Amended claims

### Amended claims in accordance with Rule 137(2) EPC.

1. A semiconductor die, comprising:
a semiconductor body (100) comprising a cell array section (610), wherein in the cell array section (610) a first surface (101) of the semiconductor body (100) comprises stripe-shaped contact areas (105) extending along a lateral first direction (901) at least from a first edge (611) of the cell array section (610) to an opposite second edge (612), wherein in portions of the contact areas (105) source regions (110) or source regions (110) and body regions (120) extend from the first surface (101) into the semiconductor body (100);
a plurality of dielectric stripes (210) formed on the first surface (101), wherein each of the dielectric stripes (210) is located between two neighboring contact areas (105) ;
a source pad portion (316) above the cell array section (610) ;
source contact structures (315) extending between the dielectric stripes (210) from the source pad portion (316) to the contact areas (105);
a plurality of dielectric bars (220) formed on at least one of the contact areas (105) at a distance to a perimeter of the cell array section (610), wherein each of the dielectric bars (220) connects two neighboring ones of the dielectric stripes (210), wherein the source regions (110) are absent below the dielectric bars (220), and wherein lateral extension regions of shielding regions (140) are formed below the dielectric bars (220), and
stripe-shaped gate electrodes (155) extending at least from the first edge (611) to the second edge (612), wherein each of the gate electrodes (155) is separated from the source pad portion (316) by a dielectric layer of the dielectric stripes (210).

2. The semiconductor die according to the preceding claim,
wherein the source pad portion (316) has a pad width (PW) along the first direction (901) and a pad length (PL) orthogonal to the first direction (901), wherein the pad length (PL) is at least 150% of the pad width (PW).

3. The semiconductor die according to any of the preceding claims,
wherein the source pad portion (316) has a top surface (317) with a top surface area (TA) comprising a bonding area (BA) smaller than the top surface (TA), and
wherein within a perimeter of the bonding area (BA), the dielectric bars (220) cover a greater area portion of the contact areas (105) than outside the perimeter of the bonding area (BA).

4. The semiconductor die according to the preceding claim,
wherein a ratio between the bonding area (BA) and the top surface area (TA) is at least 10% and at most 90%.

5. The semiconductor die according to any of the two preceding claims,
wherein the bonding area (BA) is located at a distance to at least one edge of the source pad portion (316).

6. The semiconductor die according to any of the preceding claims,
wherein at least two source pad portions (316) are arranged parallel to each other along the first direction (901).

7. The semiconductor die according to any of the preceding claims,
wherein each of the dielectric bars (220) has a bar length (BL) along the first direction (901) and a bar width (BW) orthogonal to the first direction (901), and
wherein a mean bar length (mBL) of the dielectric bars (220) is greater than the bar width (BW).

8. The semiconductor die according to any of the preceding claims,
wherein each of the source contact structures (315) extending between two neighboring ones of the dielectric bars (220) and two neighboring dielectric stripes (210) has a contact length (CL) along the first direction (901),
and wherein a mean contact length (mCL) of source contact structures (316) in contact with the same contact area (105) is smaller than a mean bar length (mBL).

9. The semiconductor die according to any of the preceding claims,
wherein a vertical extension of the dielectric stripes (210) is at least 200nm and wherein the dielectric stripes (210) comprise deposited silicon oxide.

10. A semiconductor switching assembly comprising the semiconductor die according to any of the preceding claims, further comprising:
a bond wire (850) bonded onto the source pad portion (316) of the semiconductor device (500), wherein a horizontal angle between a longitudinal axis (Lax) of the bond wire (850) and the first direction (901) is in a range from 60 degree to 120 degree.

11. The semiconductor switching assembly according to the preceding claim, further comprising:
a bond pad (810), wherein the bond wire (850) is bonded onto the bond pad (810) and connects the bond pad (810) and the source pad portion (316) of the semiconductor device (500).

12. A method of manufacturing a semiconductor switching assembly, the method comprising:
providing a bond pad (810) and the semiconductor die according to any of claims 1 to 9;
bonding a bond wire (850) onto the source pad portion (316) using ultrasonic vibrations, wherein the bonded bond wire (850) connects the bond pad (810) and the source pad portion (316), and wherein a horizontal angle between a longitudinal axis of the bond wire (850) and the first direction (901) is in a range from 60 degree to 120 degree.

13. The method according to the preceding claim, wherein
an amplitude of the ultrasonic vibration is directed parallel to the longitudinal axis (Lax) of the bond wire (850).
